# EUROPEAN PATENT SPECIFICATION

(11) **EP 2 433 543 B1**
(45) Date of publication and mention of the grant of the patent: **02.04.2014**
(21) Application number: 11182810.9
(22) Date of filing: 26.09.2011
(51) Int. Cl.: A47L 9/28, B23Q 11/00, B23D 59/00, A47L 7/00, G01R 19/165

(54) **Dust Collector**
Staubsammelvorrichtung
Dépoussiéreur

(30) Priority: 27.09.2010 JP 2010215823
(43) Date of publication of application: 28.03.2012
(73) Proprietor: Makita Corporation, Anjo, Aichi 446-8502 (JP)
(72) Inventor: Ishikawa, Goshi, Anjo,, Aichi 446-8502 (JP); Yoshida, Kazuhiko, Anjo, Aichi 446-8502 (JP)
(74) Representative: Kramer - Barske - Schmidtchen

(56) References cited:
- EP-A2- 2 080 467
- WO-A1-2010/047025
- GB-A- 1 273 428
- JP-A- 2004 195 565
- US-A- 4 998 098
- US-B1- 6 348 816

## Description

### BACKGROUND

The present invention relates to a dust collector which can be activated interlocking with activation of an electric power tool or the like.

For example, in an interlocking system of a dust collector disclosed in Patent Document 1, a transmission unit that detects activation of an electric power tool and transmits a wireless signal indicating a detection of activation is provided to the electric power tool. The dust collector (a dust collector motor) is automatically activated when the dust collector receives the wireless signal.
Patent Document 1: Japanese Unexamined Patent Application Publication No. 2008-36723

EP 2080467 A2 discloses the features of the preamble of claim 1.

### SUMMARY

However, according to experiments and studies by the inventors of the present invention, an activation timing of the dust collector is sometimes inappropriate relative to an activation timing of the electric power tool in the aforementioned interlocking system. It is an object to achieve an appropriate activation timing of a dust collector relative to an activation timing of an electric power tool.

This object is achieved by the subject-matter of claim 1.

Further developments of the invention are given in the dependent claims.

Each of assigned reference letters and numerals in the description is intended to indicate an example of a correspondence between each device in the present invention and a component in later-described embodiments. The each device in the present invention is not limited to the component represented by the reference letter or numeral in the embodiments.

In the following description the designated 'example for explaining' or 'example' do not form part of the present invention but represent background art that is useful for understanding the invention.

### BRIEF DESCRIPTION OF THE DRAWINGS

The present invention will now be described by way of example with reference to the accompanying drawings, in which:
FIG. 1 is a front elevational view of a dust collector in preferred embodiments of the present invention;
FIG. 2 is a view showing a connection state between the dust collector and an electric power tool in the preferred embodiments of the present invention;
FIG. 3 is a block diagram showing a controller of the dust collector in an example for explaining the present invention;
FIG. 4 is a flowchart illustrating an operation of the controller of the dust collector in the example for explaining the present invention;
FIG. 5 is a graph showing a current value of a current flowing in an outlet and an integrated value of the current value;
FIG. 6 is a graph showing a current value of a current flowing in an outlet and an integrated value of the current value;
FIG. 7 is a view for illustrating a definition of a current supply time T₂;
FIG. 8 is a block diagram showing a controller of a dust collector in an embodiment of the present invention;
FIG. 9A shows an example of a current waveform outputted from a current detection unit;
FIG. 9B is a chart showing an example of Case (a) in the present specification;
FIG. 9C is a chart showing an example of Case (b) in the present specification;
FIG. 9D is a chart showing an example of Case (c) in the present specification;
FIG. 10A is a flowchart showing an operation of the controller of the dust collector in the embodiment of the present invention;
FIG. 10B is a flowchart showing the operation of the controller of the dust collector in the embodiment of the present invention;
FIG. 11A is a block diagram showing a controller of a dust collector in a further example for explaining the present invention; and
FIG. 11B is a block diagram showing a controller of a dust collector in the further example for explaining the present invention.

### DETAILED DESCRIPTION OF A PREFERRED EMBODIMENT

A dust collector 1 will be described hereinafter with reference to the drawings. The dust collector 1 may be, for example, a dust collector which can be activated interlocking with activation of an electric power tool, such as an electric circular saw (a disk-shaped saw). In the present embodiment, when the dust collector 1 is activated interlocking with activation of the electric power tool, dust such as sawdust can be rapidly suctioned by the dust collector 1 before the dust is scattered around.

### [Example]

### 1. Schematic Configuration of Dust Collector

### 1.1. Appearance of Dust Collector

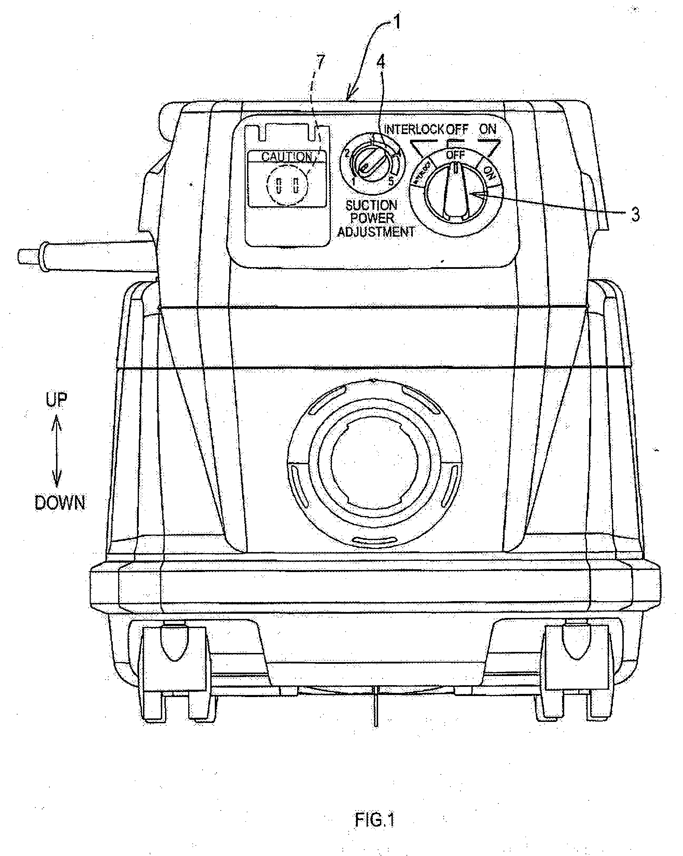

As shown in FIG. 1, an activation switch 3 of the dust collector 1, a suction power adjustment dial 4 (hereinafter simply referred to as "the adjustment dial 4") for adjusting suction power, an electric outlet 7 for supplying electric power to outside, etc. are provided in a front upper portion of the dust collector 1.

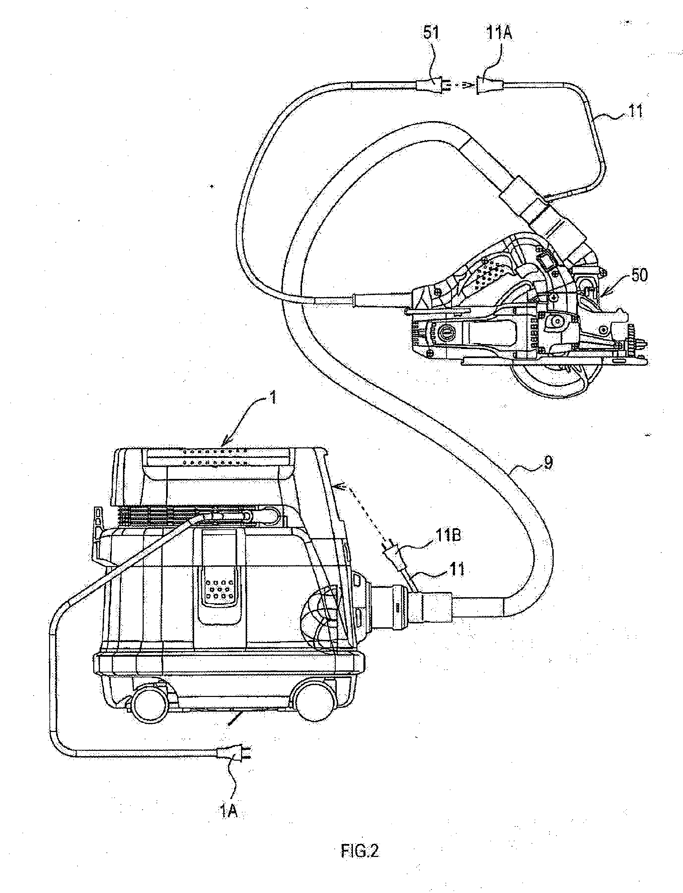

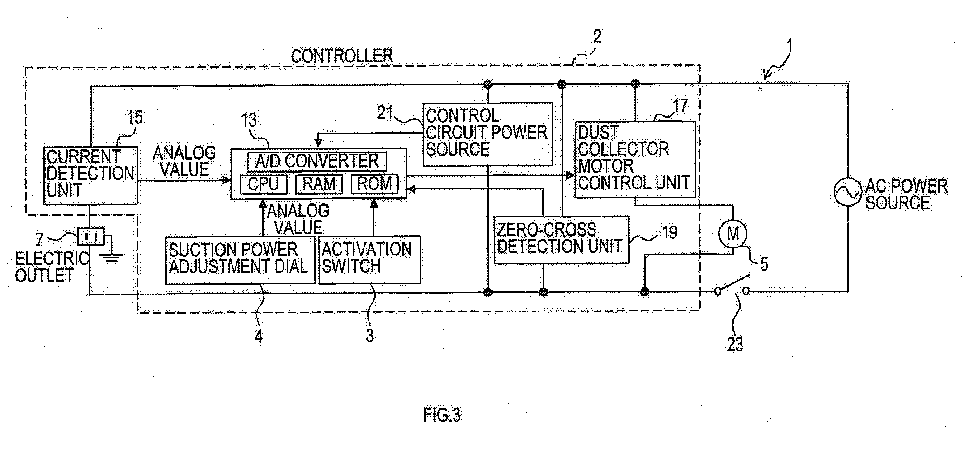

In the dust collector 1 of the present embodiment, an electric motor 5 for collecting dust (see FIG. 3) is activated when the activation switch 3 is turned to an "ON" state, while the electric motor 5 is stopped when the activation switch 3 is turned to an "OFF" state. When the activation switch 3 is turned to an "Interlock" state, an operation mode of the dust collector 1 is turned to an interlock mode. The interlock mode is a mode in which the electric motor 5 is activated and stopped interlocking with activation and stop of an electric power tool 50 (see FIG. 2) connected to the electric outlet 7.

In the dust collector 1 according to an example, as shown in FIG. 2, an extension cord 11 is integrated into a flexible hose 9 for suction. When a power plug 51 of the electric power tool 50 is inserted into an electric outlet 11A of the extension cord 11, and a plug 11B of the extension cord 11 is inserted into the electric outlet 7 (see FIG. 1), the electric power tool 50 can be indirectly connected to the electric outlet 7.

### 1.2. Controller of Dust Collector

As shown in FIG. 3, a controller 2 of the dust collector 1 includes a CPU module 13, a current detection unit 15, a dust collector motor control unit 17 (hereinafter simply referred to as "the motor control unit 17"), a zero-cross detection unit 19, a control circuit power source 21 (hereinafter simply referred to as "the power source 21"), an activation switch 3, and the adjustment dial 4. The controller 2 controls operations of the electric motor 5 and the like.

The CPU module 13 is an integrated combination of a CPU (Central Processing Unit), a ROM, a RAM, and an A/D converter. The CPU performs device control according to a program stored in the ROM. The ROM is a memory for storing programs to be executed by the CPU. The RAM is a memory for temporarily storing calculation results and the like. The A/D converter converts analog signals inputted to the CPU module 13 into digital signals.

The current detection unit 15 detects an absolute value of a current value (hereinafter referred to as a "current absolute value") of a supplied current (alternating current in the present embodiment) which is supplied through the electric outlet 7. Then, in synchronization with starting of supply of the supplied current, the current detection unit 15 inputs an analog signal indicating the detected current absolute value to the A/D converter in the CPU module 13.

The motor control unit 17 controls operation of the electric motor (electric motor for the dust collector) 5. Specifically, the motor control unit 17 adjusts an electric power supplied from a commercial power source (an AC power source) to an electric power (a voltage) corresponding to a suction power set by the adjustment dial 4, and supplies the adjusted electric power to the electric motor 5. The operation of the motor control unit 17 is controlled by the CPU module 13.

The zero-cross detection unit 19 detects a timing when a voltage of the electric power supplied from the commercial power source becomes 0 volt. The CPU module 13 controls the motor control unit 17 such that power supply to the electric motor 5 is started at the timing when the voltage of the electric power supplied from the commercial power source becomes 0 volt.

The power source 21 is a power source circuit that supplies electric power to drive control circuits such as the CPU module 13. The power source 21 converts the electric power supplied from the commercial power source into a direct current with a predetermined voltage, and supplies the electric power (direct current power) to the CPU module 13 and the like.

A main switch 23 is a manual switch that opens and closes a circuit of the electric power supplied from the commercial power source through a power plug 1A (see FIG. 2) of the dust collector 1. The main switch 23 is included in the activation switch 3 shown in FIG. 1.

When the activation switch 3 is in the "Interlock" or "ON" state, the main switch 23 is closed, and power supply to the power source 21, to the control circuits such as the CPU module 13, and to the electric outlet 7 is started, as well as power supply to the electric motor 5 becomes available.

### 2. Operation of Dust Collector of the example.

### 2.1. Outline of Operation

When the main switch 23 is closed and power supply is started, the CPU module 13 is activated, and a state of the activation switch 3 is detected. When the activation switch 3 is in the "ON" state, current supply to the electric motor 5 is started.

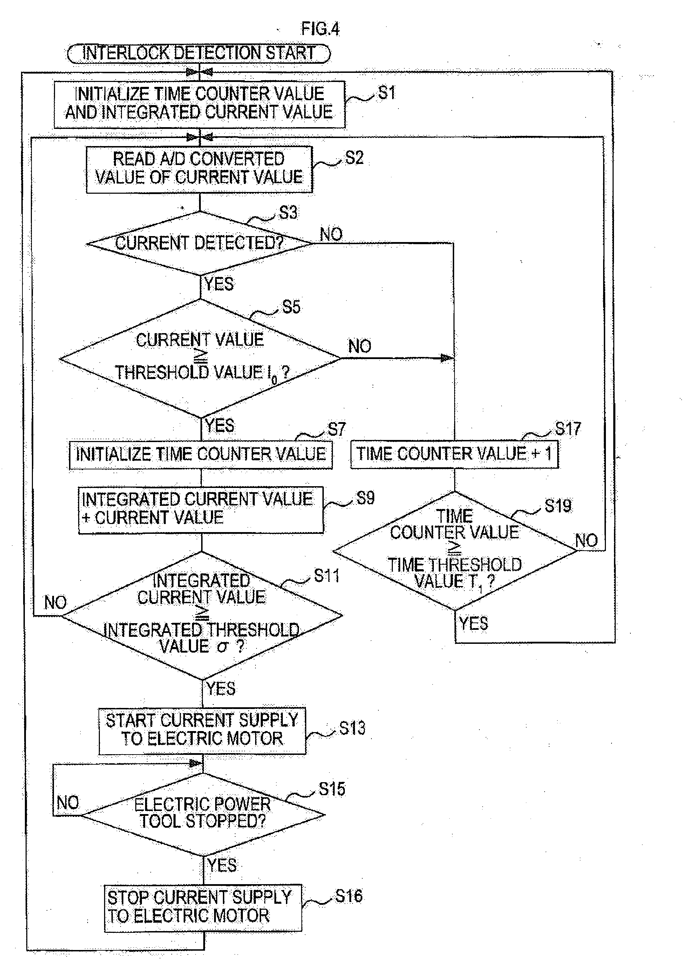

When the activation switch 3 is in the "Interlock" state, a program for performing interlocking control shown in FIG. 4 is read from the ROM and is executed by the CPU. In other words, the operation mode of the dust collector 1 is shifted to the interlock mode. When the activation switch 3 is turned from the "Interlock" state or the "ON" state to the "OFF" state, the main switch 23 is opened. Thereby, power supply to the CPU module 13 is stopped, and operation of the CPU module 13 is stopped.

Control steps (S1-S19) shown in FIG. 4 are performed at predetermined respective time intervals according to a timer (not shown) provided in the CPU module 13. Accordingly, an accumulated number of performed control steps is increased in proportion to an elapsed time from when the interlock mode is activated.

### 2.2. Interlock Mode (see FIG. 4)

Hereinafter, a "time counter value" is a value indicating a level of an elapsed time. The elapsed time is a time that has elapsed from when the time counter value is set to an initial value (0). In the present embodiment, the elapsed time becomes longer in proportion to an increase of the time counter value.

An integrated current value is a value obtained by integrating an absolute value of a current value of a supplied current from when current supply through the electric outlet 7 is started. However, the integrated current value is calculated by integrating only current values equal to or more than a later-described lower limit value I₀, in order to exclude a noise current or the like flowing through the electric power tool 50. In the present embodiment, the lower limit value I₀ is a value that is smaller than a current value of a current which is supplied during normal operation of the electric power tool 50 and can be regarded as a current value of a noise current or the like.

When the interlock mode is activated, an initial value of the time counter value ("0" in the present embodiment) and an initial value of the integrated current value ("0" in the present embodiment) are stored in the RAM (S1). Then, a digital signal indicating a current value detected by the current detection unit 15, i.e., a signal converted by the A/D converter, is read (S2).

Subsequently, it is determined whether or not a current is supplied through the electric outlet 7 based on the signal read in S2 (S3). That is, it is determined whether or not a current has been detected by the current detection unit 15. When it is determined that a current has been detected (S3: YES), it is determined whether or not the detected current value is equal to or more than a threshold value (hereinafter, the threshold value is referred to as the "lower limit value I₀") previously stored in the ROM (S5).

When it is determined that the detected current value is equal to or more than the lower limit value I₀ (S5: YES), the time counter value stored in the RAM is reset to the initial value (S7). Subsequently, the current value detected in S2, S3 is added to the integrated current value stored in the RAM, and thereby the integrated current value is updated (S9).

When the integrated current value is updated (S9), it is determined whether or not the updated integrated current value is equal to or more than a predetermined threshold value (hereinafter referred to as the "integrated threshold value σ") previously stored in the ROM (S11). When it is determined that the current value is less than the integrated threshold value σ (S11: NO), the step S2 is performed again. On the other hand, when it is determined that the current value is equal to or more than the integrated threshold value σ (S11: YES), current supply to the electric motor 5 is started (S13). Subsequently, it is determined whether or not the electric power tool 50 has stopped based on the current value detected by the current detection unit 15.

When it is determined that the electric power tool 50 has stopped (S15: YES), current supply to the electric motor 5 is stopped (S 16). Then, the step S1 is performed again. On the other hand, when it is determined that the electric power tool 50 has not stopped (S15: NO), current supply to the electric motor 5 is continued.

When it is determined in S3 that a current is not detected (S3:NO) or when it is determined in S5 that the detected current value is less than the lower limit value I₀ (S5: NO), "1" is added to the time counter value stored in the RAM and thereby the time counter value is updated (S17).

Subsequently, it is determined whether or not the updated time counter value is equal to or more than a threshold value (hereinafter the threshold value is referred to as the "time threshold value T₁") previously stored in the ROM (S19). When it is determined that the time counter value is equal to or more than the time threshold value T₁ (S19: YES) the step S1 is performed. On the other hand, when it is determined that the time counter value is less than the time threshold value T₁ (S19: NO), the step S2 is performed.

If power supply to the CPU module 13 is stopped during the interlock mode by, for example, the main switch 23 being opened, the integrated current value and the time counter value stored in the RAM are cleared at the point of time since the RAM is a volatile memory.

### 3. Features of Dust Collector of the example.

The present embodiment has a feature that current supply to the electric motor 5 is started when it is determined that a value of a parameter (hereinafter referred to as a "current parameter"), which changes depending on a state of a supplied current supplied through the electric outlet 7, satisfies a predetermined condition.

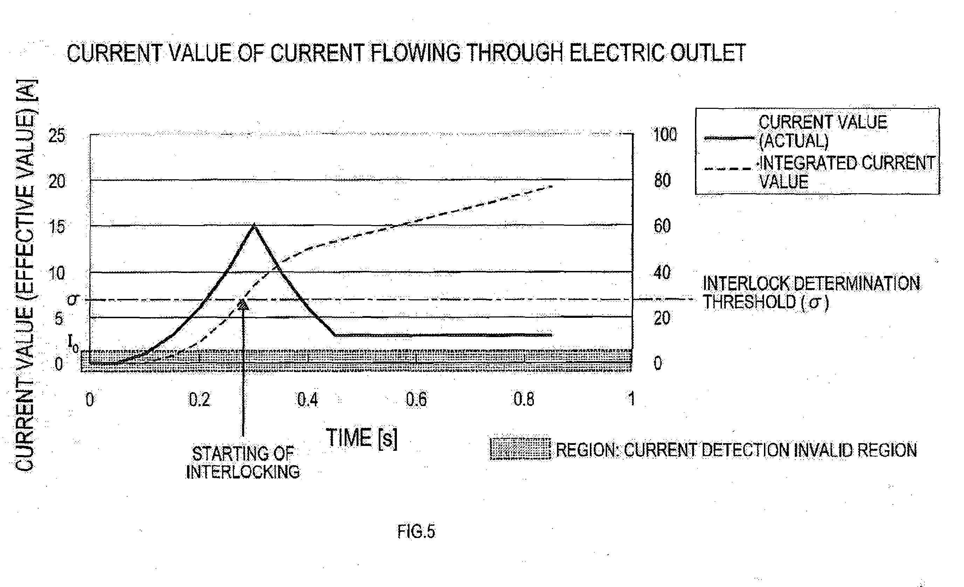

The integrated current value, which is obtained by integrating the absolute value of the current value of the supplied current from when current supply is started, is treated as a current parameter. When the current parameter (the integrated current value) is equal to or more than the integrated threshold value σ, current supply to the electric motor 5 is started (see FIG. 5).

In this case, the larger an increase rate of the current parameter is, the earlier the current parameter reaches the integrated threshold value σ (see FIG. 5). In general, it is desirable in an electric power tool having a higher increase rate of the current parameter, i.e., an electric power tool in which a larger current flows, that the dust collector 1 is activated rapidly interlocking with an activation timing of the electric power tool.

In the dust collector 1 of the present embodiment, when an electric power tool in which a larger current flows is connected to the electric outlet 7, the current parameter reaches the integrated threshold value σ early, and an activation timing of the dust collector 1 becomes early. In other words, the activation timing of the dust collector 1 can be controlled to an appropriate timing.

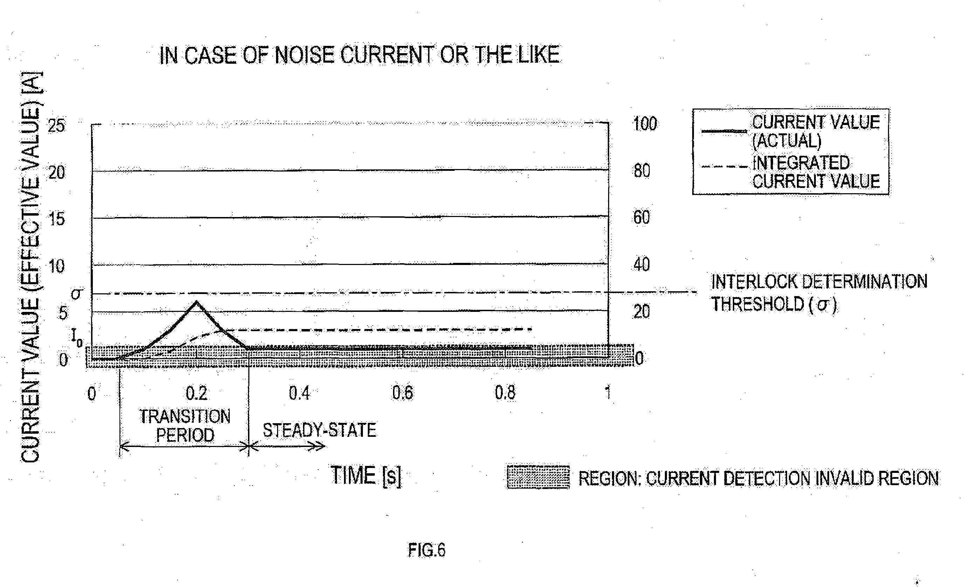

As seen from FIG. 5, a current (an inrush current) flowing in the electric power tool 50 at a moment (in a transition period) when power supply to the electric power tool 50 from the electric outlet 7 is started is larger. FIG. 6 shows an example of a noise current flowing in the electric power tool 50. Also in case of the noise current, a current value in a transition period is larger than a current value in a steady state (a steady-state current value). Therefore, if it is configured such that current supply to the electric motor 5 is started when a current value of a current flowing in the electric power tool 50 becomes equal to or more than a predetermined value, the noise current may cause malfunction of the dust collector 1.

However, a steady-state current value of a noise current is smaller than a steady-state current value during use of an electric power tool. It is, therefore, advantageous that the integrated current value is treated as the current parameter. Specifically, a configuration such that current supply to the electric motor 5 is started when the integrated current value becomes equal to or more than the integrated threshold value σ enables activation of the electric motor 5 rapidly interlocking with the activation timing of the electric power tool, while eliminating influence of the noise current (that is, avoiding erroneous starting of current supply to the electric motor 5 by the noise current), as compared with a configuration such that current supply to the electric motor 5 is started when the current value becomes equal to or more than a predetermined value.

In the steady state after the transition period terminates, the steady-state current value of the noise current is less than the lower limit value I₀, and thus the current value of the noise current is not integrated. On the other hand, the current value in the transition period (the current value of the inrush current) is large even in the case of the noise current, and thus the current value of the noise current is integrated in the transition period.

In the event that the current value of the noise current is additionally integrated to the integrated current value of the noise current, an appropriate determination on the current supply timing to the electric motor 5 cannot be made.

In contrast, when the current value of the supplied current is less than the lower limit value I₀ and also the elapsed time from when supply of the supplied current is started becomes equal to or more than the time threshold value T₁, the current parameter (the integrated current value) is reset to the initial value. In this case, it can be avoided that the current value of the noise current is additionally integrated to the integrated current value of the noise current, and thereby the integrated current value of the noise current becomes equal to or more than the integrated threshold value σ. Thus, determination on the current supply timing to the electric motor 5 can be appropriately made.

The electric outlet 7 corresponds to an example of a power supply device, and the controller which is constituted by the CPU module 13, the current detection unit 15, and the like corresponds to an example of a parameter detection device, an example of a determination device and an example of a current supply starting device.

### [Embodiment]

### 1. Outline of Dust Collector in Present Embodiment

In the above example, the integrated current value obtained by integrating the current value is used as the current parameter. In an embodiment, whether or not to start current supply to the electric motor 5 is determined based on a product of a current supply time T₂ and a number of times of shifts to the current supplied state, that is, a value equivalent to an integrated value of the current supply time T₂ from when supply of the supplied current is started.

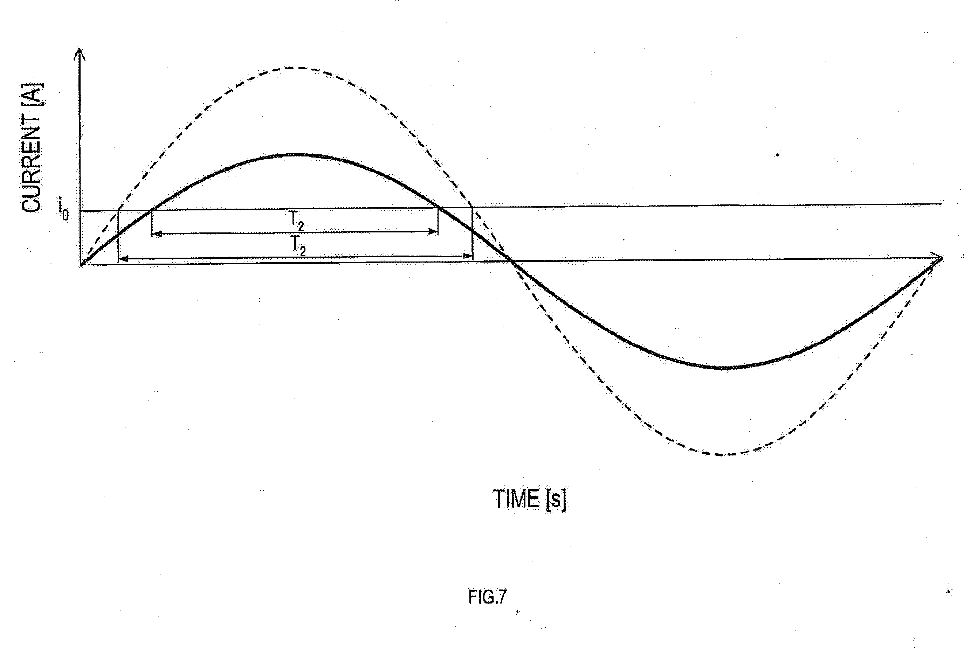

Here, the current supplied state means a state in which the absolute value of the current value of the supplied current is larger than "0" and also is equal to or more than a predetermined current value i₀, as shown in FIG. 7. The current value io is smaller than a maximum current value. Also, the current value i₀ is larger than a value of a current which may be regarded as a noise current. The current supply time T₂ means a time during which a current supplied state is present. In other words, the current supply time T₂ is a time during which the absolute value of the current value of the supplied current is equal to or more than the current value i₀. Hereinafter, the number of times of shifts to the current supplied state is referred to as the "counter value". The number of times (the counter value) is counted from the moment when supply of the supplied current is started.

In the second embodiment, a current value which is identical with the lower limit value I₀ in the above example is adopted as a value of the current value io. Hereinafter, the current value i₀ is indicated as a lower limit value io.

A frequency of the alternating current supplied through the electric outlet 7 is identical with a frequency of the commercial power source (the AC power source) regardless of the electric device, such as the electric power tool 50, connected to the electric outlet 7. If a voltage supplied through the electric outlet 7 and an electric load generated in the electric power tool 50 or the like, which is connected to the electric outlet 7, are constant, the current supply time T₂ can be constant. For example, during a very short time period at the time of activation of the electric power tool 50, the current supply time T₂ can have a value specific to each electric power tool 50 (a constant value). The larger the power consumption of the electric power tool 50 is, that is, the larger the current flowing to electric power tool 50 is, the longer the current supply time T₂ can be.

The product of the current supply time T₂ and the counter value can be a parameter characteristic of increasing in conjunction with an increase of the integrated current value. However, as described above, the current supply time T₂ can have the value specific to each electric power tool 50 (the constant value) at the time of activation of the electric power tool 50. Therefore, in the second embodiment, the counter value is used as the current parameter. A plurality of threshold values to be compared with the current parameter (the counter value) are previously stored in accordance with a length of the current supply time T₂ (in other words, in accordance with a largeness of the current flowing in the electric power tool 50). In the second embodiment, the current parameter (the counter value) is compared with the threshold value corresponding to the current parameter, and thereby a determination is made on whether or not to start current supply to the electric motor 5.

The product of the current supply time T₂ and the counter value is identical with an integrated value of the current supply time T₂ from when supply of the supplied current is started.

"Using the counter value as the current parameter" is equal to "using the integrated value of the current supply time T₂ from when supply of the supplied current is started as the current parameter" in terms of the technical meaning.

### 2. Details of Dust Collector in Present Embodiment

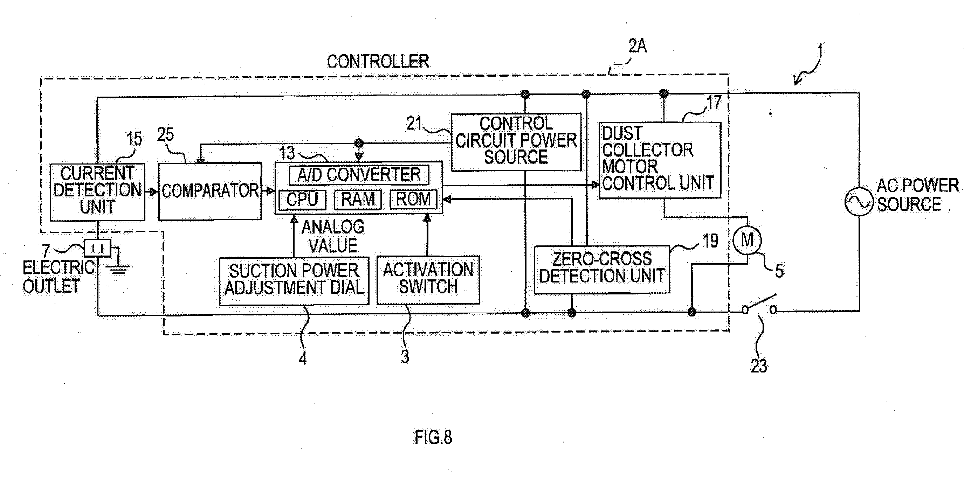

### 2.1. Controller (see FIG. 8)

The current detection unit 15 of a controller 2A in the embodiment detects only a positive current out of supplied currents which are supplied through the electric outlet 7, and outputs the detected current to a comparator 25.

The comparator 25 compares the current value of the inputted current and the lower limited value io, and outputs a signal to the CPU module 13 only while the current value of the inputted current is equal to or more than the lower limited value io, that is, only in the current supplied state. Accordingly, a time during which the comparator 25 outputs the signal is the current supply time T₂.

Among constituent devices of the controller, the same devices as in the above example are assigned the same reference numerals as in the above example, and thus no explanation thereof will be provided here.

### 2.2. Operation of Dust Collector in Present Embodiment

Overall operation of the dust controller 1 in the embodiment is the same as the operation of the dust controller 1 in the above example, and differences lie only in terms of the interlock mode. Therefore, the interlock mode will be de scribed hereinafter.

### <Outline of Interlock Mode>

In the interlock mode in the embodiment, current supply to the electric motor 5 is started when the integrated value of the current supply time T₂ from when supply of the supplied current is started, that is, the product of the current supply time T₂ and the counter value becomes equal to or more than a value σ' which corresponds to the integrated threshold value σ in the above example.

In the first embodiment, the larger the increase rate of the integrated current value is, the shorter time is required for the integrated current value to reach the integrated threshold value σ, and thus the earlier the activation timing of the dust collector 1 becomes, as described above.

In the embodiment, as described above, the number of times of shifts to the current supplied state (the counter value) is used as the current parameter, and current supply to the electric motor 5 is started when the current parameter becomes equal to or more than the threshold value which corresponds to the length of the current supply time T₂ and is previously stored in the ROM.

Here, "using the number of times of shifts to the current supplied state (the counter value) as the current parameter" is equal to "using the product of the current supply time T₂ and the counter value (in other words, an integrated value of the current supply time T₂) as the current parameter" in terms of the technical meaning. Also, the length of the current supply time T₂ means the greatness of the current value of the current supplied to the electric power tool 50. According to the embodiment, therefore, the same operation and advantages can be obtained as in the case of using the integrated current value as the current parameter.

In the embodiment, current supply to the electric motor 5 is started in either Case (a) or (b) as follows:
(a) When the current supply time T₂ is equal to or more than a first current supply time T₃, and the counter value corresponding to the current supply time T₂ becomes equal to or more than a first integrated threshold value σ1.
(b) When the current supply time T₂ is equal to or more than a second current supply time T₄, which is shorter than the first current supply time T₃, and the counter value corresponding to the current supply time T₂ becomes equal to or more than a second threshold value σ₂ which is greater than the first threshold value σ₁.

In a case excluding Cases (a) and (b) (for example, in Case (c) below), current supply to the electric motor 5 is not performed.
(c) When the current supply time T₂ is less than the second current supply time T₄.

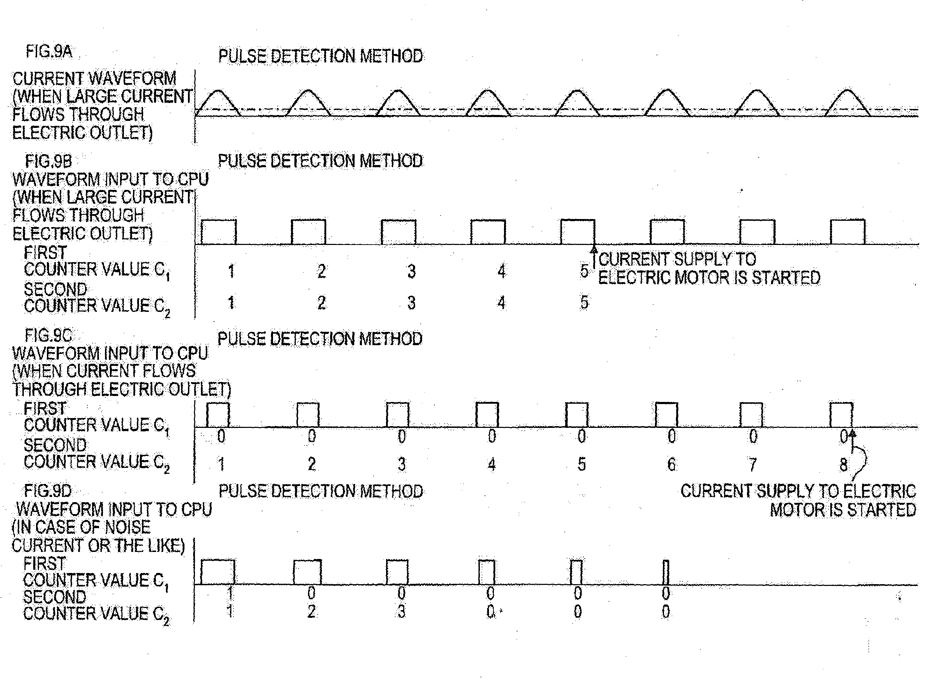

FIG. 9A shows an example of a current waveform outputted from the current detection unit 15, FIG. 9B is a chart showing an example of Case (a) above, FIG. 9C is a chart showing an example of Case (b) above, and FIG. 9D is a chart showing an example of Case (c) above.

### <Details of Interlock Mode>

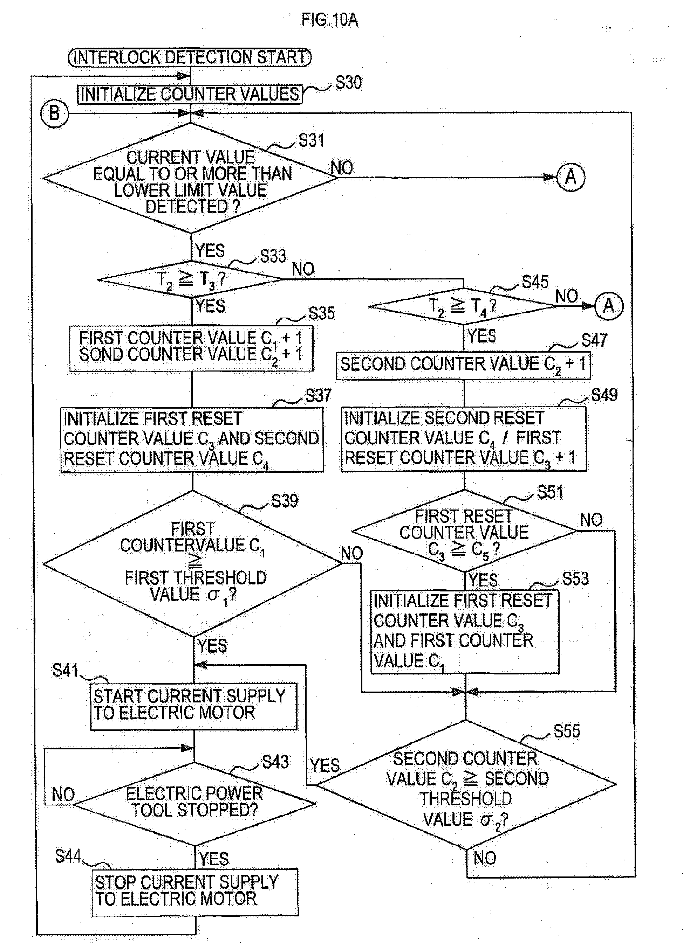

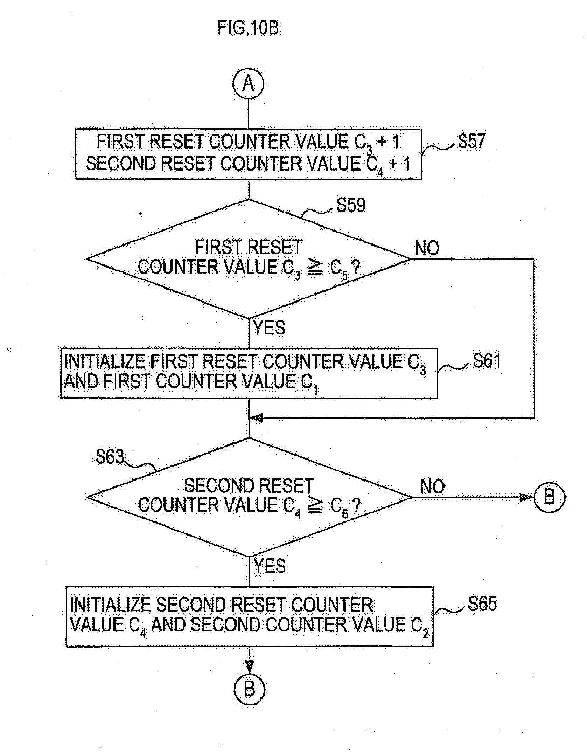

When the interlock mode is activated, as shown in FIG. 10, initial values (both are "0" in the present embodiment) of a first counter value C₁ and a second counter value C₂ as well as initial values (both are "0" in the present embodiment) of a first reset counter value C₃ and a second reset counter value C₄ for determining timings to reset the first counter value C₁ and the second counter value C₂ to the initial values are stored in the RAM (S30).

Here, the first counter value C₁ means a counter value counted corresponding to the current supply time T₂ when the current supply time T₂ is equal to or more than the first current supply time T₃ previously stored in the ROM. The second counter value C₂ means a counter value counted corresponding to the current supply time T₂ when the current supply time T₂ is equal to or more than the second current supply time T₄ previously stored in the ROM.

Subsequently, it is determined whether or not a current value equal to or more than the lower limit value io has been detected, that is, it is determined whether or not a signal has been outputted from the comparator 25 (S31). When it is determined that a current value equal to or more than the lower limit value io has been detected (S31: YES), it is then determined whether or not the current supply time T₂ is equal to or more than the first current supply time T₃ (S33).

When it is determined that the current supply time T₂ is equal to or more than the first current supply time T₃ (S33: YES), "1" is added to each of the first counter value C₁ and the second counter value C₂ stored in the RAM, and thereby the first counter value C₁ and the second counter value C₂ are updated (S35). Also, the first reset counter value C₃ and the second reset counter value C₄ are reset to the respective initial values (S37).

Next, it is determined whether or not the first counter value C₁ is equal to or more than the first threshold value σ₁ previously stored in the ROM (S39). When it is determined that the first counter value C₁ is equal to or more than the first threshold value σ₁ (S39: YES), current supply to the electric motor 5 is started (S41).

Subsequently, it is determined whether or not the electric power tool 50 has been stopped based on the current value detected by the current detection unit 15 (S43). When it is determined that the electric power tool 50 has been stopped (S43: YES), current supply to the electric motor 5 is stopped (S44). Then, the step S30 is performed again. On the other hand, when it is determined that the electric power tool 50 has not been stopped (S43: NO), current supply to the electric motor 5 is continued.

When it is determined in S39 that the first counter value C₁ is not equal to or more than the first threshold value σ₁ (S39: NO), it is then determined whether or not the second counter value C₂ is equal to or more than the second threshold value σ₂ previously stored in the ROM (S55). When it is determined that the second counter value C₂ is equal to or more than the second threshold value σ₂ (S55: YES), current supply to the electric motor 5 is started (S41). On the other hand, when it is determined that the second counter value C₂ is not equal to or more than the second threshold value σ₂ (S55: NO), the step S31 is performed again.

When it is determined in S33 that the current supply time T₂ is less than the first current supply time T₃ (S33: NO), it is then determined whether or not the current supply time T₂ is equal to or more than the second current supply time T₄ (S45).

When it is determined that the current supply time T₂ is equal to or more than the second current supply time T₄ (S45= YES), "1" is added to the second counter value C₂ stored in the RAM and thereby the second counter value C₂ is updated (S47). Then, "1" is added to the first reset counter value C₃ and thereby the first reset counter value C₃ is updated, and the second reset counter value C₄ is reset to the initial value (S49).

Subsequently, it is determined whether or not the first reset counter value C₃ is equal to or more than a first reset threshold value C₅ previously stored in the ROM (S51). When it is determined that the first reset counter value C₃ is less than the first reset threshold value C₅ (S51: NO), the step S55 is performed.

On the other hand, when it is determined that the first reset counter value C₃ is equal to or more than the first reset threshold value C₅ (S51: YES), it means that a state, in which the current supply time T₂ is less than the first current supply time T₃, has been continued for a predetermined time period or longer. Therefore, the first counter value C₁ and the first reset counter value C₃ are reset to the respective initial values (S53).

That is, in the second embodiment, the step S31 is performed at a zero-cross timing of the supplied current in synchronization with a frequency of the supplied current supplied from the electric outlet 7, except when the electric motor 5 is activated. Therefore, when the first reset counter value C₃ is equal to or more than the first reset threshold value C₅, the state, in which the current supply time T₂ is less than the first current supply time T₃, has been continued for a time period that is determined by a product of the frequency of the supplied current and the first reset threshold value C₅.

Accordingly, in the second embodiment, when the first reset counter value C₃ is equal to or more than the first reset threshold value C₅, it is rewarded that an electric power tool, which requires such a large current that the current supply time T₂ is equal to or more than the first current supply time T₃, is not connected to the electric outlet 7 at least currently (when the step S53 is performed). Thus, the first counter value C₁, which is a current parameter to make a determination on the activation of the electric power tool requiring a large current, is reset to the initial value.

Also, when it is determined in S31 that a current value equal to or more than the lower limit value io is not detected (S31: NO), or when it is determined in S45 that the current supply time T₂ is less than the second current supply time T₄ (S45: NO), "1" is added to each of the first reset counter value C₃ and the second reset counter value C₄, and thereby the first reset counter value C₃ and the second reset counter value C₄ are respectively updated (S57).

Subsequently, it is determined whether or not the first reset counter value C₃ is equal to or more than the first reset threshold value C₅ (S59). When it is determined that the first reset counter value C₃ is equal to or more than the first reset threshold value C₅ (S59: YES), the first counter value C₁ and the first reset counter value C₃ are reset to the respective initial values (S61) for the same reason as in S53, and then the step S63 is performed.

On the other hand, when it is determined that the first reset counter value C₃ is less than the first reset threshold value C₅ (S59: NO), it is then determined whether or not the second reset counter value C₄ is equal to or more than a second reset threshold value C₆ previously stored in the ROM (S63).

When it is determined that the second reset counter value C₄ is equal to or more than the second reset threshold value C₆ (S63: YES), the second counter value C₂ and the second reset counter value C₄ are reset to the respective initial values (S65). Then, the step S31 is performed again. On the other hand, when it is determined that the second reset counter value C₄ is less than the second reset threshold value C₆ (S63: NO), the second counter value C₂ or the like is not reset and the step S31 is performed again.

The reason for resetting the second counter value C₂ and the second reset counter value C₄ to the respective initial values when the second reset counter value C₄ is equal to or more than the second reset threshold value C₆ is as follows: It can be regarded that an electric power tool, which requires such a large current that the current supply time T₂ is equal to or more than the second current supply time T₄, is not connected to the electric outlet 7 currently (when the step S63 is performed) in a same manner as in S53.

### 3. Features of Dust Collector of Present Embodiment

The case where the first counter value C₁ is equal to or more than the first threshold value σ₁, or the case where the second counter value C₂ is equal to or more than the second threshold value σ₂ means the same as the case where the integrated value of the current supply time T₂, from when supply of the supplied current is started (that is, when the current value equal to or more than the lower limit value io is detected in S31), becomes equal to or more than a predetermined threshold value. Accordingly, the configuration of the second embodiment may also be referred to as a configuration in which current supply to the electric motor 5 is started when the current parameter becomes equal to or more than a predetermined threshold value. The current parameter is the integrated value of the current supply time T₂ from when supply of the supplied current is started.

As aforementioned, the product of the current supply time T₂ and the first counter value C₁, or the product of the current supply time T₂ and the second counter value C₂ is a parameter which is characteristic of becoming greater in conjunction with an increase of the integrated current value. The longer the current supply time T₂ is, the greater an increase rate of the current integrated value becomes.

When it is configured such that the threshold value corresponding to the number of times of shifts to the current supplied state becomes larger as a value of the current supply time T₂ is smaller, as in the second embodiment, the dust collector 1 is activated more rapidly interlocking with the activation timing of an electric power tool as a larger current flows in the electric power tool. Thus, the activation timing of the dust collector 1 may be controlled to an appropriate timing.

Also, in the embodiment, when a state in which the current supply time T₂ is less than the first current supply time T₃ has been continued for a time period defined by the first reset threshold value C₅, the first counter value C₁ is reset to the initial value. When a state in which the current supply time T₂ is less than the second current supply time T₄ has been continued for a time period defined by the second reset threshold value C₆, the second counter value C₂ is reset to the initial value.

As such, in the embodiment, when an integrated time during which the current supply time T₂ cannot be detected has reached a predetermined time, the first counter value C₁ or the second counter value C₂ as the current parameter is reset to the initial value. Therefore, an unnecessary counter value (the current parameter) is not considered when determining the current supply timing to the electric motor 5, and thus an appropriate determination on the current supply timing to the electric motor 5 can be made.

### 4. Correspondence between Invention Specifying Matters and Present Embodiment

In the embodiment, the electric outlet 7 corresponds to an example of a power supply device, and the controller which is constituted by the CPU module 13, the current detection unit 15, the comparator 25, and the like corresponds to an example of a parameter detection device, an example of a determination device and an example of a current supply starting device.

### [Further example]

While the threshold values (the integrated threshold value σ, the first threshold value σ₁, and the second threshold value σ₂) to determine whether or not to start current supply to the electric motor 5 are fixed values stored in the ROM in the first and second embodiments, the threshold values are configured to be variable by a user's operation in a further example.

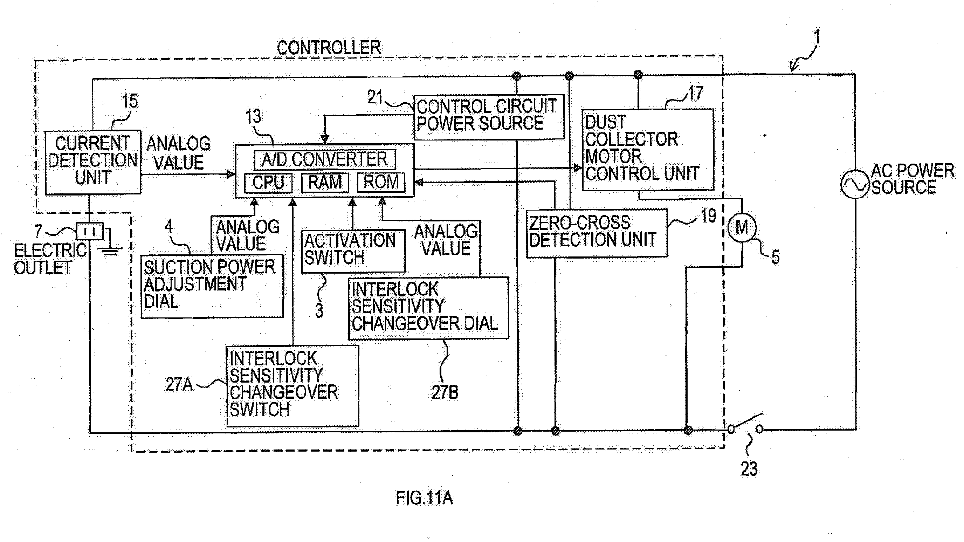

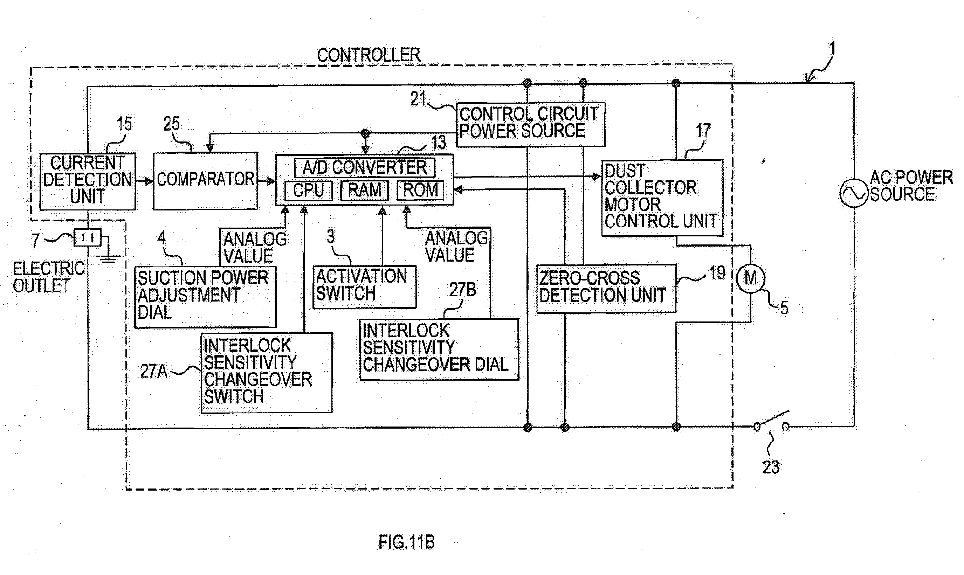

Specifically, as shown in FIG. 11A and FIG. 11B, the dust collector 1 includes a condition changing device, such as an interlock sensitivity changeover switch 27A (hereinafter simply referred to as the "changeover switch 27A") or an interlock sensitivity changeover dial 27B (hereinafter simply referred to as the "changeover dial 27B"), to change the threshold values.

The changeover switch 27A is a switch for stepwisely changing a time from when the electric power tool is activated until when the electric motor 5 is activated (hereinafter referred to as the "interlock sensitivity"). The interlock sensitivity changeover dial 27B is a switch for continuously changing the interlock sensitivity. According to the third embodiment, the activation timing of the dust collector 1 may be further appropriately controlled.

In the first and second embodiments, the threshold values cannot be directly changed since the threshold values are stored in the ROM. Therefore, a value obtained by multiplying each of the threshold value stored in the ROM by a parameter is used as a threshold value to determine whether or not to start current supply to the electric motor 5, and the interlock sensitivity is changed by changing the parameter using the changeover switch 27A or the like.

FIG. 11A shows an example in which the further example is applied to the controller in the above example. FIG. 11B shows an example in which the further example is applied to the controller in the embodiment.

### [Other Embodiments]

While an alternating current which periodically changes its current value and current direction is supplied through the electric outlet 7 in the above-described embodiments, the present invention is not limited to such configuration, but may be applied to a case where a direct current which periodically changes its current value is supplied. Especially in the first embodiment, a direct current with a constant current value may be used.

Also, while the current waveform inputted to the comparator 25 is a waveform obtained by half-wave rectification of the current supplied through the electric outlet 7 in the second embodiment, the present invention is not limited to such configuration, and a full-wave rectified waveform may be employed.

Further, while the threshold value is indirectly changed in the third embodiment, the present invention is not limited to such configuration. For example, the threshold value may be stored in a rewritable non-volatile storage device and be directly changed by the condition changing device, such as the changeover switch 27A.

Moreover, while the integrated current value or the like is used as the parameter (the current parameter) which changes depending on the state of supplied current supplied through the electric outlet 7 in the above-described embodiments, the present invention is not limited to such configuration.

While the integrated current value as the current parameter is detected (calculated) by the CPU module 13 in the first embodiment, the present invention is not limited to such configuration. For example, the integrated current value may be calculated using hardware such as an integration circuit.

In the second embodiment, the integrated value of the current supply time T₂ as the current parameter, that is, the first counter value C₁ or the like is detected (calculated) by the CPU module 13, the comparator 25, or the like, the present invention is not limited to such configuration. For example, the current parameter may be detected using hardware constituted by a combination of an integration circuit and a comparator or the like.

While current supply to the electric motor 5 is stopped when a supplied current from the electric outlet 7 becomes unable to be detected, in the above-described embodiments, the present invention is not limited to such configuration. For example, current supply to the electric motor 5 may be stopped when a predetermined time has elapsed after the supplied current from the electric outlet 7 becomes unable to be detected. This enables the electric motor 5 to be stopped after dust in the flexible hose 9 is suctioned.

## Claims

1. A dust collector (1) for suctioning dust, comprising:
an electric motor (5) for collecting dust;
a power supply device (7) that is adapted to supply electric power;
a parameter detection device that is adapted to detect a current parameter which changes depending on a state of a current supplied by the power supply device (7);
a determination device that is adapted to determine whether or not a value of the current parameter detected by the parameter detection device satisfies a condition based on a threshold value stored in a first storage unit; and
a current supply starting device that is adapted to start current supply to the electric motor (5) when it is determined by the determination device that the value of the current parameter satisfies the condition, wherein
the power supply device (7) is adapted to supply electric power having a periodically changing current value, **characterized in that**
when a state, in which the absolute value of the current value of the supplied current is more than "0" and also is equal to or more than a predetermined current value that is less than a maximum current value, is referred to as a "current supplied state", a time during which the current supplied state is present is referred to as a "current supply time", and a number of times of shifts to the current supplied state from when supply of the supplied current is started is referred to as a "counter value", the parameter detection device is adapted to detect the counter value as the current parameter,
wherein a plurality of threshold values to be compared with the counter value are previously stored in accordance with a length of the current supply time T₂ for a determination whether to start current supply to the electric motor (5) or not by comparing the counter value with the threshold value corresponding to the counter value.

2. The dust collector (1) according to claim 1, wherein
the parameter detection device is adapted to detect an integrated current value, which is obtained by integrating the absolute value of the supplied current from when supply of the current is started, as the current parameter.

3. The dust collector (1) according to claim 2, wherein
the first storage unit is adapted to store a first threshold value indicating a threshold value of the integrated current value, and
the determination device is adapted to determine that the value of the current parameter satisfies the condition when the value of the current parameter is equal to or more than the first threshold value.

4. The dust collector (1) according to claim 3, wherein
the parameter detection device is adapted to reset the current parameter to an initial value when an integrated time, which is obtained by integrating a time during which the current value of the supplied current is less than a second threshold value stored in a second storage unit, exceeds a third threshold value stored in a third storage unit.

5. The dust collector (1) according to any of claims 1 to 4, wherein
the power supply device (7) is adapted to supply electric power having a periodically changing current value, and
when a time, during which the absolute value of the current value of the supplied current is more than "0" and also is equal to or more than a predetermined current value that is less than a maximum current value, is referred to as a "current supply time", the parameter detection device is adapted to detect, as the current parameter, an integrated value of the current supply time from when supply of the supplied current is started.

6. The dust collector (1) according to claim 5, wherein
the first storage unit is adapted to store a fourth threshold value indicating a threshold value of the integrated value of the current supply time, and
the determination device is adapted to determine that the value of the current parameter satisfies the condition when the value of the current parameter is equal to or more than the fourth threshold value.

7. The dust collector (1) according to claim 1, wherein
the first storage unit is adapted to store a fifth threshold value indicating a threshold value of the counter value corresponding to the current supply time, the fifth threshold value being set to be larger as the current supply time is shorter, and
the determination device is adapted to determine that the value of the current parameter satisfies the condition when the value of the current parameter is equal to or more than the fifth threshold value.

8. The dust collector (1) according to any of claims 5 to 7, wherein
the parameter detection device is adapted to reset the current parameter to an initial value when an integrated time, which is obtained by integrating the time during which the current supply time is unable to be detected, exceeds a sixth threshold value stored in the first storage unit.

9. The dust collector (1) according to any of claims 1 to 8, further comprising a condition changing device that is configured to change a value indicating the condition and is operable by a user.

## Patentansprüche

1. Staubsammelvorrichtung (1) zum Ansaugen von Staub, enthaltend:
einen Elektromotor (5) zum Sammeln von Staub;
eine Leistungsversorgungsvorrichtung (7), die angepasst ist zum Liefern einer elektrischen Leistung;
eine Parameterdetektionsvorrichtung, die angepasst ist zum Detektieren eines Stromparameters, der sich in Abhängigkeit von einem Zustand eines Stroms, der durch die Leistungsversorgungsvorrichtung (7) geliefert wird, ändert;
eine Bestimmungsvorrichtung, die angepasst ist zum Bestimmen, ob ein Wert des Stromparameters, der durch die Parameterdetektionsvorrichtung detektiert wird, eine Bedingung erfüllt, basierend auf einem Schwellenwert, der in einer ersten Speichereinheit gespeichert ist; und
eine Stromlieferstartvorrichtung, die angepasst ist zum Starten einer Stromlieferung an den Elektromotor (5), wenn durch die Bestimmungsvorrichtung bestimmt wird, dass der Wert des Stromparameters die Bedingung erfüllt, wobei
die Leistungsversorgungsvorrichtung (7) angepasst ist zum Liefern einer elektrischen Leistung, die einen sich periodisch ändernden Stromwert aufweist, **dadurch gekennzeichnet; dass**
wenn ein Zustand, bei dem der absolute Wert des Stromwerts des gelieferten Stroms größer als "0" ist und ebenso gleich oder größer als ein vorbestimmter Stromwert ist, der kleiner ist als ein maximaler Stromwert, als ein "Strom-geliefert-Zustand" bezeichnet wird, wird eine Zeit, während der der Strom-geliefert-Zustand vorhanden ist, als eine "Stromlieferzeit" bezeichnet, und eine Anzahl von Zeitpunkten von Verschiebungen zu dem Strom-geliefert-Zustand ab dem Start der Lieferung des gelieferten Stroms als "Zählerwert" bezeichnet wird, die Parameterdetektionsvorrichtung angepasst zum Detektieren des Zählerwerts als den Stromparameter,
wobei eine Mehrzahl von Schwellenwerten, die mit dem Zählerwert zu vergleichen sind, vorab gemäß einer Länge der Stromlieferzeit T₂ gespeichert wird für eine Bestimmung, ob die Stromlieferung an den Elektromotor (5) gestartet werden soll, oder nicht, indem der Zählerwert mit dem Schwellenwert, der dem Zählerwert entspricht, verglichen wird.

2. Staubsammelvorrichtung (1) nach Anspruch 1, bei der
die Parameterdetektionsvorrichtung angepasst ist zum Detektieren eines integrierten Stromwerts, der erlangt wird, indem der absolute Wert des gelieferten Stroms integriert wird, beginnend mit dem Start der Lieferung des Stroms, als den Stromparameter.

3. Staubsammelvorrichtung (1) nach Anspruch 2, bei der
die erste Speichereinheit angepasst ist zum Speichern eines ersten Schwellenwerts, der einen Schwellenwert des integrierten Stromwerts angibt, und
die Bestimmungsvorrichtung angepasst ist zum Bestimmen, dass der Wert des Stromparameters die Bedingung erfüllt, wenn der Wert des Stromparameters gleich oder größer ist als der erste Schwellenwert.

4. Staubsammelvorrichtung (1) nach Anspruch 3, bei der
die Parameterdetektionsvorrichtung angepasst ist zum Zurücksetzen des Stromparameters auf einen Anfangswert, wenn eine integrierte Zeit, die erlangt wird, indem eine Zeit, während der der Stromwert des gelieferten Stroms kleiner ist als ein zweiter Schwellenwert, der in einer zweiten Speichereinheit gespeichert ist, einen dritten Schwellenwert, der in einer dritten Speichereinheit gespeichert ist, übersteigt, integriert wird.

5. Staubsammelvorrichtung (1) nach einem der Ansprüche 1 bis 4, bei der
die Leistungsversorgungsvorrichtung (7) angepasst ist zum Liefern einer elektrischen Leistung, die einen sich periodisch ändernden Stromwert aufweist, und
wenn eine Zeit, während der der absolute Wert des Stromwerts des gelieferten Stroms größer als "0" ist und ebenso gleich oder größer als ein vorbestimmter Stromwert, der kleiner ist als ein maximaler Stromwert, als eine "Stromlieferzeit" bezeichnet wird, die Parameterdetektionsvorrichtung angepasst ist zum Detektieren, als Stromparameter, eines integrierten Werts der Stromlieferzeit beginnend mit dem Start der Lieferung des gelieferten Stroms.

6. Staubsammelvorrichtung (1) nach Anspruch 5, bei der
die erste Speichereinheit angepasst ist zum Speichern eines vierten Schwellenwerts, der einen Schwellenwert des integrierten Werts der Stromlieferzeit angibt, und
die Bestimmungsvorrichtung angepasst ist zum Bestimmen, dass der Wert des Stromparameters die Bedingung erfüllt, wenn der Wert des Stromparameters gleich oder größer ist als der vierte Schwellenwert.

7. Staubsammelvorrichtung (1) nach Anspruch 1, bei der
die erste Speichereinheit angepasst ist zum Speichern eines fünften Schwellenwerts, der einen Schwellenwert des Zählerwerts angibt, der der Stromlieferzeit entspricht, wobei der fünfte Schwellenwert festgelegt ist, größer zu sein, wenn die Stromlieferzeit kürzer ist, und
die Bestimmungsvorrichtung angepasst ist zum Bestimmen, dass der Wert des Stromparameters die Bedingung erfüllt, wenn der Wert des Stromparameters gleich oder größer ist als der fünfte Schwellenwert.

8. Staubsammelvorrichtung (1) nach einem der Ansprüche 5 bis 7, bei der
die Parameterdetektionsvorrichtung angepasst ist zum Zurücksetzen des Stromparameters auf einen Anfangswert, wenn eine integrierte Zeit, die erlangt wird durch Integrieren der Zeit, während der die Stromlieferzeit nicht detektiert werden kann, einen sechsten Schwellenwert, der in der ersten Speichereinheit gespeichert ist, übersteigt.

9. Staubsammelvorrichtung (1) nach einem der Ansprüche 1 bis 8, ferner enthaltend eine Bedingungsänderungsvorrichtung, die ausgelegt ist zum Ändern eines Werts, der die Bedingung angibt, und durch einen Benutzer bedienbar ist.

## Revendications

1. Un collecteur de poussière (1) agencé pour aspirer la poussière, comprenant :
un moteur électrique (5) pour collecter la poussière ;
un dispositif d'alimentation de puissance (7) qui est destiné à fournir de la puissance électrique ;
un dispositif de détection de paramètre qui est destiné à détecter un paramètre de courant qui varie en fonction d'un état d'un courant fourni par le dispositif d'alimentation de puissance (7) ;
un dispositif de détermination qui est destiné à déterminer dans quelle mesure une valeur du paramètre de courant détecté par le dispositif de détection satisfait à une condition de valeur seuil stockée dans une première unité de stockage ; ou non et
un dispositif de démarrage de l'alimentation en courant qui est destiné à démarrer l'alimentation en courant vers le moteur électrique (5) lorsqu'il est établi par le dispositif de détermination que la valeur du paramètre de courant satisfait la condition,
dans lequel le dispositif d'alimentation de puissance (7) est destiné à fournir de la puissance électrique présentant une valeur de courant variable de manière périodique,
**caractérisé en ce que**, lorsqu'un état, dans lequel la valeur absolue de la valeur de courant du courant fourni est supérieure à « 0 » et si elle est également égale ou supérieure à une valeur prédéterminée de
courant qui est inférieure à une valeur maximale de courant, est qualifié « d'état alimenté en courant », une période pendant laquelle l'état alimenté en courant est présent est qualifiée de « période d'alimentation en courant », et un nombre de fois où l'état alimenté en courant est décalé à partir du moment où l'alimentation en courant fourni a démarré est qualifié de « contre-valeur », le dispositif de détection de paramètre est agencé pour détecter la contre-valeur comme paramètre de courant,
dans lequel une pluralité de valeurs seuils destinées à être comparée à la contre-valeur sont préalablement stockées selon la durée de la période d'alimentation en courant T₂ pour déterminer s'il y a lieu ou pas de démarrer l'alimentation en courant vers le moteur électrique (5) en comparant la contre-valeur à la valeur seuil correspondant à la contre-valeur.

2. Le collecteur de poussière (1) selon la revendication 1, dans lequel le dispositif de détection de paramètre est destiné à détecter une valeur de courant intégrée, laquelle étant est obtenue en intégrant la valeur absolue du courant fourni à partir du moment où l'alimentation du courant a démarré, en tant que paramètre de courant.

3. Le collecteur de poussière (1) selon la revendication 2, dans lequel la première unité de stockage est destinée à stocker une première valeur seuil indiquant une valeur seuil de la valeur de courant intégré, et
le dispositif de détermination est destiné à déterminer que la valeur du paramètre de courant satisfasse la condition lorsque la valeur du paramètre de courant est égale ou supérieure à la première valeur seuil.

4. Le collecteur de poussière (1) selon la revendication 3, dans lequel le dispositif de détection de paramètre est destiné à réinitialiser le paramètre de courant à une valeur initiale lorsqu'une période intégrée, qui est obtenue en intégrant une période durant laquelle la valeur de courant du courant fourni est inférieure à une deuxième valeur seuil stockée dans une deuxième unité de stockage, dépasse une troisième valeur seuil stockée dans une troisième unité de stockage.

5. Le collecteur de poussière (1) selon l'une quelconque des revendications 1 à 4, dans lequel le dispositif d'alimentation en puissance (7) est destiné à fournir de la puissance électrique présentant une valeur de courant variable de manière périodique, et lorsqu'une période, durant laquelle la valeur absolue de la valeur de courant du courant fourni est supérieure à « 0 » et si elle est également égale ou supérieure à une valeur prédéterminée de courant qui est inférieure à une valeur maximale de courant, est qualifié « d'état alimenté en courant », le dispositif de détection de paramètres est agencé pour détecter, comme paramètre de courant, une valeur intégrée de la période d'alimentation en courant à partir du moment où l'alimentation en courant fourni a démarré.

6. Le collecteur de poussière (1) selon la revendication 5, dans lequel la première unité de stockage est destinée à stocker une quatrième valeur seuil indiquant une valeur seuil de la valeur intégrée de la période d'alimentation en courant, et
le dispositif de détermination est destiné à déterminer que la valeur du paramètre de courant satisfasse la condition lorsque la valeur du paramètre de courant est égale ou supérieure à la quatrième valeur seuil.

7. Le collecteur de poussière (1) selon la revendication 1, dans lequel la première unité de stockage est destinée à stocker une cinquième valeur seuil indiquant une valeur seuil de la contre-valeur correspondant à la période d'alimentation en courant, la cinquième valeur seuil étant définie de façon à augmenter lorsque la période d'alimentation en courant diminue, et
le dispositif de détermination est destiné à déterminer que la valeur du paramètre de courant satisfasse à la condition lorsque la valeur du paramètre de courant est égale ou supérieure à la cinquième valeur seuil.

8. Le collecteur de poussière (1) selon l'une quelconque des revendications 5 à 7, dans lequel dispositif de détection de paramètres est destiné à réinitialiser le paramètre de courant à une valeur initiale lorsqu'une période intégrée, qui est obtenue en intégrant une période durant laquelle la période d'alimentation en courant n'est pas susceptible d'être détectée, dépasse une sixième valeur seuil stockée dans la première unité de stockage.

9. Le collecteur de poussière (1) selon l'une quelconque des revendications 5 à 8, comprenant en outre un dispositif de modification de condition qui est configuré pour modifier une valeur indiquant la condition et est utilisable par un utilisateur.
